Europäisches Patentamt

European Patent Office

Office européen des brevets

(19)

(11) Publication number: **0 030 856**
**B1**

(12) **EUROPEAN PATENT SPECIFICATION**

(45) Date of publication of patent specification: **21.03.84**

(21) Application number: **80304496.5**

(22) Date of filing: **12.12.80**

(51) Int. Cl.³: **H 01 L 27/10,**
**G 11 C 11/34,**
**H 01 L 27/12,**
**H 01 L 21/322**

(54) **Charge-pumping semiconductor memory cell comprising a charge-storage region and memory device using such a cell.**

(30) Priorlty: **13.12.79 JP 162078/79**
**19.12.79 JP 165231/79**

(43) Date of publication of application:
**24.06.81 Bulletin 81/25**

(45) Publication of the grant of the patent:
**21.03.84 Bulletin 84/12**

(84) Designated Contracting States:
**DE FR GB**

(56) References cited:
**FR - A - 2 200 634**
**FR - A - 2 335 045**
**US - A - 4 035 826**

**INTERNATIONAL ELECTRON DEVICES
MEETING, TECHNICAL DIGEST, 4-6 December
1978, Washington, US, N. SASAKI et al.:
"Charge pumping SOS-MOS transistor memory",
pages 356-359
INTERNATIONAL ELECTRON DEVICES
MEETING, TECHNICAL DIGEST, 6-8 December
1976, Washington, US, S. ASAI et al.: "Back-
gate-input MOS, a new low-power logic
concept", pages 185-187**

(73) Proprietor: **FUJITSU LIMITED**
**1015, Kamikodanaka Nakahara-ku
Kawasaki-shi Kanagawa 211 (JP)**

(72) Inventor: **Sakurai, Junji**
**7-11, Seta 4-chome Setagaya-ku
Tokyo 158 (JP)**
Inventor: **Sasaki, Nobuo**
**1-14-240, Kawara-cho Saiwai-ku
Kawasaki-shi Kanagawa 210 (JP)**

(74) Representative: **Bedggood, Guy Stuart et al,
Haseltine Lake & Co. Hazlitt House 28
Southampton Buildings Chancery Lane
London WC2A 1AT (GB)**

Courier Press, Leamington Spa, England.

# Charge-pumping semiconductor memory cell comprising a charge-storage region and memory device using such a cell

This invention relates to a charge pumping semiconductor memory cell and a semiconductor memory device using such cells.

This invention is concerned with a so-called charge pumping semiconductor memory cell (hereinafter referred to as a CP memory cell) of which the concept was disclosed in the already allowed US Patent Application Serial No. 960917. A CP memory cell is virtually a MIS FET formed in a semiconductor region which is electrically isolated from or floating on a substrate made of a semiconductor or an insulator such as sapphire.

If a CP memory cell is an N-channel MIS FET, information is written into the CP memory cell when the source is grounded and the drain is supplied with a positive voltage, and then the gate is supplied with a positive voltage which is higher than the threshold voltage of the N-channel MIS FET and then the gate voltage is suddenly removed. Since a channel is formed in the semiconductor region under the gate before the gate voltage is suddenly removed, some minority carriers remain confined in the semiconductor region when the gate voltage is suddenly removed. This phenomenon is known as the charge pumping effect. The minority carriers confined in the semiconductor region are effective to charge up the same semiconductor region. As a result, the potential of the semiconductor region shifts from a neutral value. In the case of an N-channel MIS FET, the semiconductor region is charged with electrons to a negative potential. The charges (electrons) remain confined in the semiconductor region under the gate for a considerable length of time, because the region is electrically isolated from or floating on a substrate. Therefore, the semiconductor region is referred to as a charge storage region. Since the above-mentioned potential situation is identical to that in which a MIS FET has applied thereto a back gate bias, the threshold voltage of the MIS FET is altered as a result of the back gate effect. In this case (N-channel), the threshold voltage is increased.

As a result, a condition is available in which the magnitude of gate voltage which would allow the MIS FET to pass a current prior to the charge pumping action or prior to information writing action, will not allow the same transistor to pass a current after the charge pumping action or the information writing action. This change in characteristics can be utilized for identification of information written in a CP memory cell. Namely, when reading information written in a CP memory cell, a voltage is applied between the source and the drain, while the gate is supplied with a voltage selected from the voltage range between the original threshold voltage of the CP memory cell when memorising a piece of information representing a low level (i.e. before or in the absence of charge pumping) and the threshold voltage of the CP memory cell as increased as a result of charge pumping action or information writing action, and the information stored in the cell is picked up in the form of a current.

The information written in a CP memory cell can be erased by removing the charge stored in the charge storage region or by supplying a charge of the opposite polarity to the charge stored in the charge storage region. More specifically, various means have been proposed for this purpose as described below.

Firstly, information can be erased by writing or irradiating the memory cell with light. In this case, if a number of memory cells are all heated or irradiated information is concurrently erased from all the cells.

Secondly, information can be erased by supplying to the gate of a memory cell approximately the same voltage as was applied to write information and by gradually removing that same voltage, so that the charge pumping effect is not caused. In this case, an individual memory cell can be selectively erased of information.

Thirdly, information can be erased employing avalanche multiplication. In other words, a fairly high voltage is applied between source and drain of the memory cell so as to cause avalanche multiplication for P—N junctions between the charge storage region and the source and drain regions, which results in the release of charge from the charge storage region.

Various types of semiconductor memory devices are available which use pluralities of CP memory cells.

For example, the performance criteria which are important for a CP memory cell, as a result of the principles which govern the way in which information is written into a CP memory cell, are discussed below. A first important performance criterion is charge pumping efficiency which is defined as the ratio of electric charges recombined with majority carriers contained in the charged storage region and the entire quantity of electric charges injected into the charge storage region at the moment when the gate voltage is suddenly removed. The second important criterion is the charge sustaining time which is defined as the length of the period for which the charges stay inside the charge storage region. The former depends on the quantity or number of recombination centres available in a charge storage region and the latter depends on junction leakage which further depends on crystal quality around P—N junctions isolating a charge storage region from other portions of a CP memory cell.

When a CP memory cell is formed on an insulator such as sapphire, good charge pumping efficiency is expected as a result of a considerable quantity or number of recombination centres being available in the charge storage region, albeit that charge sustaining time is short. Results of our experiments for such a memory cell show a charge pumping efficiency of approximately 50%, which is fairly good, but a charge sustaining time of 0.3 msec, which is rather bad. When a CP memory cell is formed on a semiconductor substrate, charge pumping efficiency turns out to be extremely bad. Results of our experiments for such a memory cell show a charge pumping efficiency of less than $10^{-2}$%, which is extremely bad, but a charge sustaining time of 300 msec—3 sec, which is fairly good.

As a result, a CP memory cell formed on a semiconductor substrate is not necessarily appropriate for actual use due to the unsatisfactory magnitude of the charge pumping efficiency.

On the other hand, since production cost is extremely high for any SOS type semiconductor device, neither is a CP memory cell formed on an insulator such as a sapphire appropriate for actual use, from the point of view of cost.

Further, it is recognised that from the point of view of means of erasing information, a CP memory cell can be inconvenient. It may be clear that means for erasing information employing the avalance multiplication is the most realistic of the different possible means described above. This, however, has a drawback in that two independent power supplies of different voltages are required.

A semiconductor memory device employing a plurality of CP memory cells has, of course, the same drawbacks as the individual cells employed. As a result, such a device is not necessarily appropriate for actual use for the reasons given above.

The Technical Digest, International Electron Devices meeting, 4—6 December 1978, Washington USA, pages 356 to 359, discloses a charge pumping memory cell formed on sapphire.

According to the present invention there is provided a charge pumping semiconductor memory cell comprising a semiconductor substrate of one conductivity type, a charge storage region, of opposite conductivity type to the semiconductor substrate, on or in the substrate, a source and a drain, on or in the charge storage region, a gate, on a gate insulator layer, on the charge storage region and separating the source and drain, said charge storage region being electrically floating and for storing charge carriers, characterised in that a region with an introduced plurality of recombination centres is provided in the charge storage region separate from the source and the drain, and beneath a zone in which a channel of the cell is generated, to capture minority charge carriers generated under said gate whereby charge pumping efficiency is increased.

A semiconductor memory device embodying this invention and utilising a plurality of such memory cells is also provided.

An embodiment of the present invention can provide a CP memory cell formed on a semiconductor substrate which has a good charge pumping efficiency and a long charge sustaining time.

An embodiment of the present invention can provide a CP memory cell formed on a semiconductor substrate from which it is easy to erase information employing only one power supply.

An embodiment of the present invention can provide a semiconductor memory device which includes CP memory cells formed on a semiconductor substrate and which has a good charge pumping efficiency and a long charge sustaining time.

An embodiment of the present invention can provide a semiconductor memory device which includes CP memory cells formed on a semiconductor substrate and from which it is easy to erase information employing only one power supply.

In an embodiment of the present invention semiconductor memory cells, each of which virtually is a MIS FET whose threshold voltage varies depending on whether or not information is written therein, whereby the information can be read out in the form of an electric current, is provided.

To provide for good charge pumping efficiency and long charge sustaining time, a CP memory cell embodying this invention is provided with a number of recombination centres implanted in the charge storage region. Such recombination centres are implanted in an area where an inversion layer spreads, but leaving a space into which a channel depletion layer can extend without disturbance. That is, recombination centres are implanted under a zone in which a channel is generated in the memory cell when it is in use. The materials to be implanted are selected from materials which require a lesser or relatively low amount of energy to be deeply implanted into a charge storage region and which have a lesser or relatively low magnitude of diffusion rate, such as oxygen (O), carbon (C), nitrogen (N), argon (Ar) and fluorine (F) et al. Such recombination centres implanted in a charge storage region which is formed in a semiconductor layer of a good crystal quality are effective in improving charge pumping efficiency without adversely affecting charge sustaining time. As a result, a CP memory cell embodying this invention can exhibit a charge pumping efficiency of approximately 70% and a charge sustaining time range of 300 msec to 3 sec, depending on crystal condition.

To provide for ease of erasing information using only one power supply, a CP memory cell embodying this invention is a type of complementary MIS FET which comprises a CP memory cell proper formed on a semi-conductor substrate and having a good charge pumping efficiency and a long charge sustaining time as mentioned above, and a complementary or additional transistor which has a channel of a different conductivity type from that of the CP memory cell proper and the source or drain of which contacts the charge storage region of the CP memory cell proper. The semiconductor substrate and the drain or source of the complementary or additional transistor which does not contact the charge storage region of the CP memory cell proper are supplied with $V_{DD}$ which is usually 5 V. The drain of the CP memory cell proper is supplied with $V_{SS}$ which is usually ground level. The source of the CP memory cell proper is supplied with $V_0$ which is usually a voltage less than 5 V. Information is written in the CP memory cell proper when the gates of both CP memory cell proper and the complementary or additional transistor are supplied with $V_G$ which is usually 5 V, and information is erased when the two gates are both supplied with $V_{SS}$ because the complementary or additional transistor supplies majority carriers to the charge storage region of the CP memory cell proper, as a result returning the electrical potential of the charge storage region of the CP memory cell proper to a neutral position. As a result, information is easily erased without the need for two independent power supplies.

To provide a semiconductor memory device with a plurality of CP memory cells of good charge pumping efficiency and long charge sustaining time, a plurality of CP memory cells formed on a semiconductor substrate and having a good charge pumping efficiency and a long charge sustaining time as mentioned above are utilised in accordance with this invention. As a result, the memory device can require much smaller semiconductor chip surface area and can be efficient in writing and sustaining information therein. Further, various circuit configurations simpler than could previously be used can be allowed for in the device.

To provide a semiconductor memory device having a plurality of CP memory cells on a semiconductor substrate which are easily erasable using only one power supply, a plurality of complementary MIS FET type CP memory cells which are easily erasable using only one power supply are utilised in the semiconductor memory device. As a result, the device can enjoy various advantages inherent in complementary MIS FET type CP memory cells.

Reference is made, by way of example, to the accompanying drawings, in which:—

Figure 1 is a schematic cross-sectional view of a part of a semiconductor wafer after completion of a third step in the production of a CP memory cell embodying this invention, formed on a semiconductor substrate and having a good charge pumping efficiency and a long charge sustaining time.

Figure 2 is a schematic cross-sectional view of a part of a semiconductor wafer after completion of a fourth step in the production of a CP memory cell embodying this invention, formed on a semiconductor substrate and efficient in writing and sustaining information.

Figure 3 is a schematic cross-sectional view of a CP memory cell embodying this invention, formed on a semiconductor substrate and efficient in writing and sustaining information, for assistance in explanation of the function of a CP memory cell,

Figure 4 is a schematic cross-sectional view of another CP memory cell embodying this invention, which is efficient in writing and sustaining information,

Figure 5 is a schematic cross-sectional view of a CP memory cell embodying this invention which can easily be erased using only one power supply,

Figure 6 is a schematic cross-sectional view of another CP memory cell embodying this invention, which can easily be erased using only one power supply,

Figure 7 is a schematic cross-sectional view of a further CP memory cell embodying this invention, which can easily be erased using one power supply,

Figure 8 is a schematic circuit wiring diagram of a semiconductor memory device embodying this invention utilising CP memory cells formed on a semiconductor substrate and which are efficient in writing and sustaining information.

Figure 9 is a schematic circuit wiring diagram of another semiconductor memory device embodying this invention, in which CP memory cells are formed on a semiconductor substrate and are efficient in writing and sustaining information, and

Figure 10 is a schematic circuit wiring diagram of a semiconductor memory device embodying this invention utilising CP memory cells which are easy to erase using only one power supply.

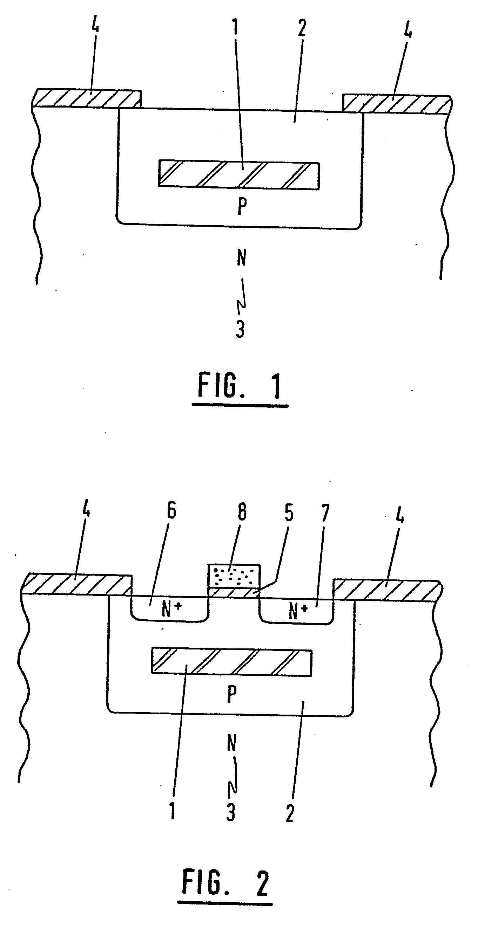

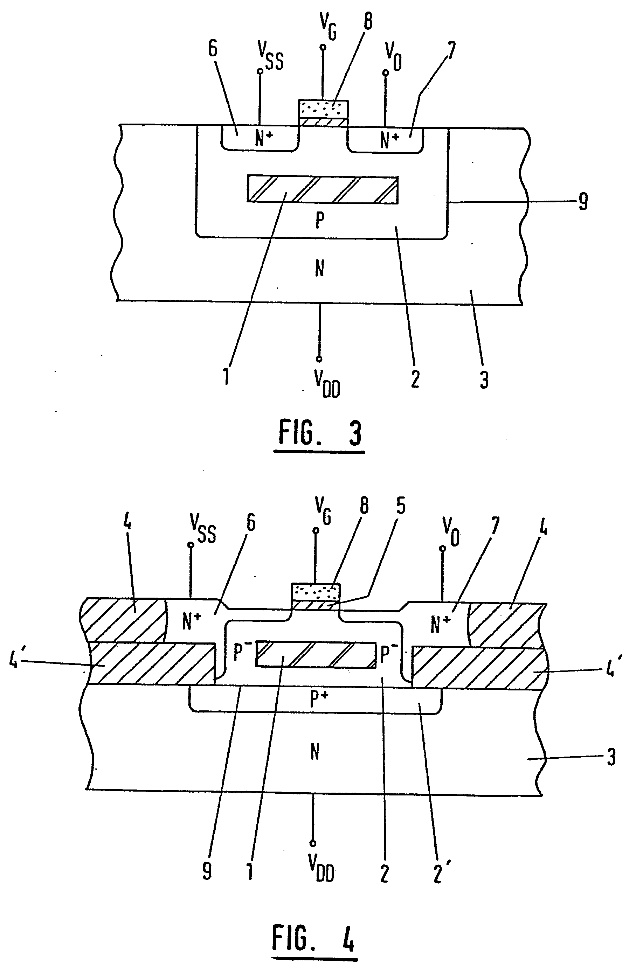

With reference to Figures 1 to 4, steps for production of, the arrangement and configuration of, and each element of a CP memory cell embodying this invention which is formed on a semiconductor substrate and which has a good charge pumping efficiency and a long charge sustaining time, will be described in relation to a case in which the CP memory cell is produced on an N-doped silicon substrate.

A first step is to form a silicon oxide layer on a top surface of the substrate to produce a field insulator layer, before an opening for a P-type well is etched through the field silicon oxide layer by means of a lithography process.

A second step is to form a P-type well in the area from which the field silicon oxide layer has been removed. Any conventional method can be used for this step.

Referring to Figure 1, a third step is to introduce a number of recombination centres 1 into the P-type well 2 formed in the N-doped substrate 3, which substrate is covered by a field silicon oxide layer 4 except in an area in which the P-type well 2 is formed. The area in which the recombination centres 1 are implanted can be selected anywhere within an area in which an inversion layer is formed in the memory cell when in use. It is clear, however, that such recombination centres must not extend into such areas as would result in disturbance of a channel formed in the memory cell when in use. This, it will be readily understood, means that the recombination centres are implanted beneath a zone in which a channel is generated in the finished memory cell when appropriate voltages are applied to gate, source and drain of the memory cell as explained below. The materials to be implanted to provide the recombination centres can be selected from those materials which require a lesser or relatively low amount of energy to be implanted to the required depth into the P-type well 2 and which have a lesser or relatively low magnitude of diffusion rate. Such materials include oxygen (O), carbon (C), nitrogen (N), argon (Ar), and fluorine (F) and the like.

Referring to Figure 2, a fourth step is to form a gate insulator layer 5 selectively in isolation on the top surface of P-type well 2, and a source 6 and a drain 7 both of which are N± doped areas, and are produced by implanting an N-dopant, before a gate 8 provided by a polysilicon (polycrystal silicon) layer is formed on top of the gate insulator layer 5.

A fifth step is to produce terminals (not shown) which provide ohmic contacts with the source 6, the drain 7, the gate 8, and the N-substrate 3 respectively, before a passivation layer (not shown) is formed over the entire surface of the wafer excepting over bonding pads (not shown).

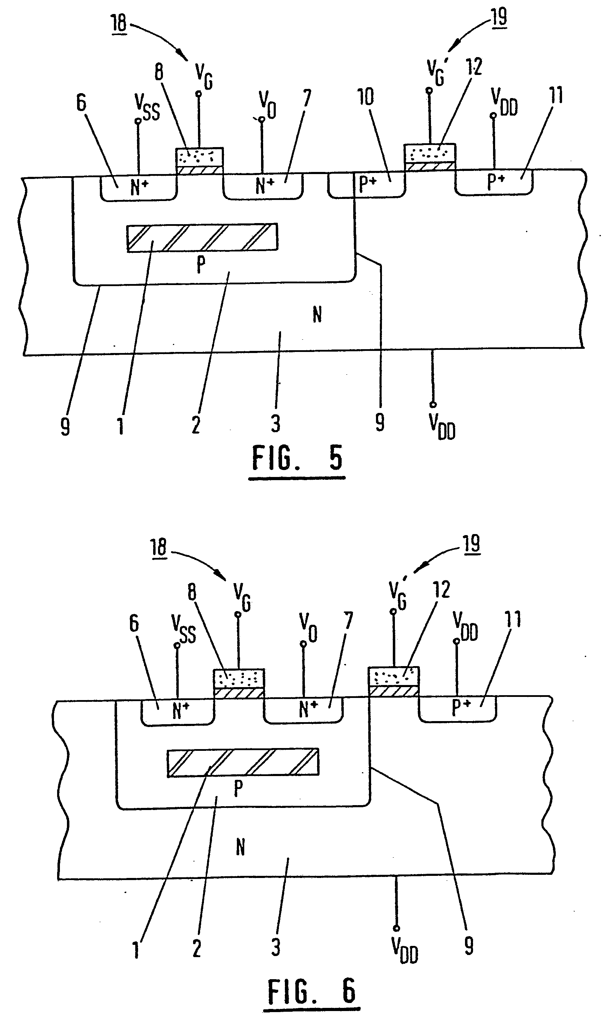

Referring to Figure 3, a CP memory cell embodying this invention formed on a semi-conductor substrate and which is efficient in writing and sustaining information has information written therein in the following manner. The N-substrate 3, the source 6 and the drain 7 are respectively supplied with a more positive voltage $V_{DD}$, for example 5 V, a ground voltage $V_{SS}$, for example OV, and a less positive voltage $V_O$ for example 2 V. Incidentally, the gate 8 is supplied with a positive voltage $V_G$, for example 5 V, before that voltage is suddenly removed. This set of actions causes the charge pumping effect to inject a quantity of electrons into the P-type well 2. These pumped electrons are confined for a length of time in the P-type well or charge storage region 2 as a result of the presence of a P—N junction 9 which is located between the P-type well or charge storage region 2, and the substrate 3 and which is reverse biased.

The electrons, of course, charge up the P-type well or charge storage region 2 to a negative potential, causing a back gate effect to increase the threshold voltage of the CP memory cell. This change in threshold voltage enables the CP memory cell to function as a memory cell.

The introduction of a number of recombination centres 1 into the P-type well or charge storage region 2 improves charge pumping efficiency, because charge pumping efficiency is defined as the ratio of electron charges recombined with majority carriers (holes in this case) contained in the P-type well or charge storage region 2 to the entire quantity of electric charges confined in or injected into the charge storage region 2. In reality, results of experiments have shown that the charge pumping efficiency can be increased to approximately 70%, for example, from a magnitude of less than $10^{-2}$% which is the corresponding efficiency for a similar CP cell without the introduction of recombination centres.

On the other hand, since the crystal quality of the P-type well 2 is fair, junction leakage across the P—N junction 9 is very small. Therefore, charge sustaining time is also fair. In reality, results of experiments have shown that charge substaining time can be maintained in the range 300 msec—3 sec for example.

As a result a CP memory cell formed on a semiconductor substrate and embodying this invention has a good charge pumping efficiency and a long charge sustaining time.

Of course, this invention can be employed in various different ways. One example of another embodiment is illustrated in Figure 4. The difference between the first embodiment described above with reference to Figures 1 to 3 and the second embodiment in Figure 4, predominantly relates to the production methods used. Namely, for the embodiment of Figure 4, after a $P^+$-silicon layer 2' has been formed in an N-doped silicon substrate 3, a silicon dioxide layer 4' is formed on the surface of the substrate 3 and an opening for a charge storage region 2 is etched through layer 4', before a $P^-$-silicon layer 2 is formed on the $P^+$-silicon layer 2' and on the silicon dioxide layer 4'. Then, after the $P^-$-silicon layer 2 has been oxidised (to provide oxide layer 4) except in an area in which a CP memory cell is to be formed, recombination centres 1 are implanted into layer 2 by means employing a resist mask. After the resist mask has been removed, a gate insulator layer 5 and a gate 8 are formed, before N-dopant is implanted to form an $N^+$-source 6 and an $N^+$-drain 7 as shown in Figure 4.

With reference to Figures 5 to 7, the arrangement and configuration of each element of a CP memory cell embodying this invention which allows easy erasure of information without requiring two independent power supplies will be described below, in relation to a case in which a CP memory cell is produced in a P-type well formed in an N-doped silicon substrate.

Referring to Figure 5, a number of recombination centres 1 are implanted in a P-type well or charge storage region 2 formed in an N-doped substrate 3. On a top surface of the P-type well or charge storage region 2, a source 6 and a drain 7, both of which are provided by $N^+$-doped areas, are provided surrounding a gate 8. A P-channel transistor is formed in the same N-doped substrate 3, and an additional drain 10 (of the P-channel transistor) is arranged across a P—N junction 9 which isolates the P-type well or charge storage region 2 from the substrate 3. An additional source 11 (of the P-channel transistor) is provided at the surface of the N-doped substrate 3. An additional gate 12 is arranged to separate the additional drain 10 and the additional source 11. The gates 8 and 12 may be connected to one another (see below).

Referring again to Figure 5, a CP memory cell embodying this invention which allows easy erasure of information using only one power supply has information written therein in the same manner as for the CP memory cell described above with reference to Figures 1 to 3. Namely, the N-substrate 3, the source 6 and the drain 7 are respectively supplied with a more positive voltage $V_{DD}$, for example 5 V, a ground voltage $V_{SS}$, for example $0_v$, and a less positive voltage $V_0$, for example 2 V. Incidentally, both gates 8 and 12 are supplied with a positive voltage $V_G$, for example 5 V. This potential position causes the CP memory cell proper 18 to form a channel in the P-type well or charge storage region 2, while the complementary or additional transistor 19 is kept in an OFF condition. Thereafter, when the gate voltage is suddenly removed, an item of information is written in the CP memory cell proper 18 as a result of the charge pumping effect. Needless to say, a good charge pumping efficiency and a long charge sustaining time are expected respectively because of the existence of a number of recombination centres 1 implanted in the charge storage region 2, and the good crystal quality of the charge storage region 2.

To read information, the gate 8 is supplied with a voltage selected from the voltage range between the original threshold voltage of the CP memory cell when memorising a piece of information representing a low level (i.e. before or in the absence of charge pumping) and the threshold level of the CP memory cell proper 18 as increased after an information writing action (i.e. after charge pumping), for example 2.5 V. A voltage in this range is used so as to keep the CP memory cell proper 18 in an OFF condition. Otherwise, it would be impossible to retain a piece of stored information. On the other hand, the gate 12 is supplied with a positive voltage, for example 5 V. This is to keep the complementary or additional transistor 19 in an OFF condition.

However, in a case in which the complementary or additional transistor 19 is so produced as to have a threshold voltage such that the same transistor 19 would not be shifted to an ON position by the application to the gate 12 of the voltage to be applied to the gate 8 of the CP memory cell proper 18 for reading information, the gate 8 and the gate 12 can accept the same voltage for reading information. As a result, gates 8 and 12 can be permanently connected. This is, of course, effective in simplifying wiring configuration.

To erase information, both gates 8 and 12 are supplied with a zero voltage, causing the complementary transistor 19 to be placed in an ON condition. This causes the additional drain (10) to be supplied with a number of positive charges or holes. Since the additional drain 10 and the P-type well or charge storage region 2 are at the same potential, the P-type well or charge storage region 2 is resultantly supplied with a considerable quantity of positive charges and is returned to a neutral potential. This of course returns the threshold voltage of the CP cell proper to its original value, or a value which corresponds to a condition of the cell in which no information is written therein (i.e. before or in the absence of charge pumping). This means that the information can be erased by application of a zero voltage. As a result, in accordance with this invention, a CP memory cell in which erasure of information is facilitated without the need for two independent power supplies of two different magnitudes of voltage is provided.

This invention can be embodied in various different ways.

A further embodiment is illustrated in Figure 6. The difference between the embodiment of Figure 5 described above and the embodiment of Figure 6 is that the additional gate 12 is formed in self-alignment with P—N junction 9 and additional drain 10 is eliminated. The additional drain 10 of the embodiment of Figure 5 has no terminal and is at the same potential as the P-type well or charge storage region 2. This means that the additional drain 10 can be eliminated, using the P-type well or charge storage region 2 as a drain for the complementary or additional transistor 19. The function of the embodiment of Figure 6 is precisely identical to that of the embodiment of Figure 5.

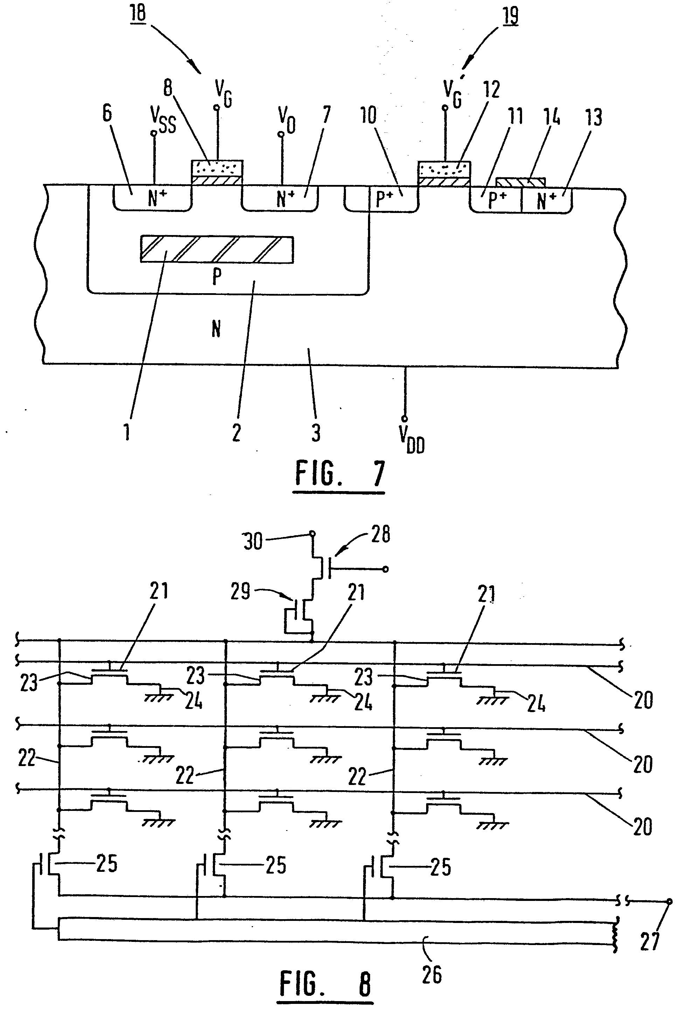

Another embodiment is illustrated in Figure 7. The difference between the embodiment of Figure 5 described above and the embodiment of Figure 7 is that the additional source 11 of the complementary or additional transistor 19 is supplied with a positive voltage $V_{DD}$ from a terminal connected with the substrate 3 through an $N^+$-silicon region 13 and wiring 14 connecting the $N^+$-silicon region 13 and the additional source 11. This allows the elimination of a terminal for the additional source 11.

A combination of the embodiments of Figure 6 and 7 can be provided.

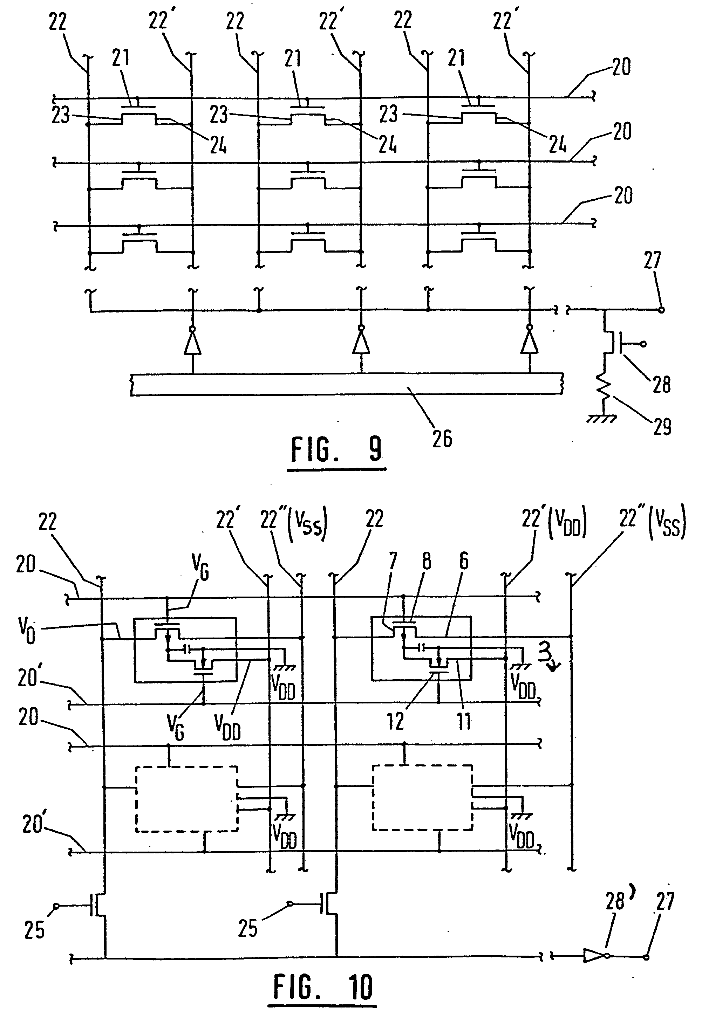

With reference to Figures 8 and 9, the wiring and the function of a semiconductor memory device embodying this invention which utilises CP memory cells each of which is formed on a semiconductor substrate and each of which has a good charge pumping efficiency and a long charge sustaining time, will be described.

In Figure 8, each of a number of word lines 20 is connected with the gates 21 of a number of CP memory cells in a respective row. Each of a number of bit lines 22 is connected with the drains 23 of a number of CP memory cells in a respective column. All the sources 24 of the CP memory cells are grounded. Each of the bit lines 22 is provided with a switching element 25, regulated by a column decoder 26 for selection of an arbitrary column, and which is connected with an input-output terminal 27. All of the bit lines 22 are commonly connected through a common load 29 with an input-output control switching element 28 and a positive voltage power supply terminal 30. The semi-conductor memory device is provided with control units for selection of an arbitrary one of the word lines 20 and refreshment of the memory.

When a piece of information is written in the semiconductor memory device, one of the bit lines 22 is selected and one of the word lines 20 is selected, and then the selected word line has applied thereto a positive voltage and is then suddenly released from that voltage, to cause the charge pumping effect. On the other hand, when a piece of information is read out of the semiconductor memory device, one of the word lines 20 is selected and one of the bit lines 22 is selected in accordance with an address, and then the selected word line 20 is supplied with a positive voltage. If a piece of information "1" is memorized in the addressed CP memory cell, a current signal flows out of the input-output terminal 27, because the CP memory cell refuses to pass a current. If a piece of information "0" is memorized in the CP memory cell, no current flows out of the input-output terminal 27, because the CP memory cell will pass a current which flows to earth.

Since each of the CP memory cells has a good charge pumping efficiency and a long charge sustaining time, a semiconductor memory device which is efficient in writing and sustaining information is provided, in accordance with this invention. In addition, cost advantage can be significant.

Figure 9 shows another example of the wiring in a semiconductor memory device embodying this invention utilizing CP memory cells each of which is formed on a semiconductor substrate and each of each has a good charge pumping efficiency and a long charge sustaining time. It is noted that this wiring is particularly applicable to CP memory cells. Similar elements are given the same reference numerals as employed in Figure 8. The function and the features of the wiring of Figure 9 are similar to those of the wiring shown in Figure 8.

With reference to Figure 10, the wiring and the function of a semiconductor memory devide embodying this invention which utilizes CP memory cells which are easy to erase using only one power supply will be described.

Referring to Figures 5 and 10, each of the word lines 20 in Figure 10 is connected with gates 8 of all the CP memory cells proper 18 and the additional gates 12 of all the complementary or additional transistors 19 in a respective row. Each of the bit lines 22 is connected with the drains 7 of all the CP memory cells proper 18 included in a respective column. All the sources 6 of the CP memory cells proper 18 are grounded. Each of $V_{DD}$ lines 22' is connected with the additional drains 11 of all the complementary or additional transistors 19 and the substrate 3. Each of the $V_{SS}$ lines 22'' is connected with the sources of the CP memory cells proper. Each of the bit lines 22 is provided with a switching element 25 for selection of an arbitrary column. The switching elements 25 are commonly connected with an input output terminal 27 through a sense amplifier 28'.

The functions of the semiconductor memory device embodying this invention which utilizes CP memory cells from which it is easy to erase information employing only one power supply whose wiring is as shown in Figure 10 are quite similar to the others. The only difference is that the information is written in to a specific memory cell, when the gates 8 and 12 of the specific memory cell are supplied with a positive voltage $V_G$, and that information is easily erased from a specific memory cell, when the gates 8 and 12 of the specific memory cell are supplied with a zero voltage $V_{SS}$, without requiring two independent power supplies of different potentials.

The functions of a so-called charge pumping semiconductor memory cell depend on the charge pumping efficiency and on the charge sustaining time, both of which further depend on the crystal quality of a semiconductor region where the charges are stored (a charge storage region). In embodiments of this invention a number of recombination centres are interleaved or implanted in a charge storage region of good crystal quality, which effectively improves both of the above mentioned parameters.

An additional transistor with a channel of the opposite conductivity type to the CP memory cell proper which is formed on the same substrate in such a way that its drain contacts the charge storage region of the CP memory cell proper can provide for effective erasure of information written into the so-called charge pumping (CP) semiconductor memory cell, when the gates of both the additional transistor and of the CP memory cell proper are connected together and the additional transistor is ON while the memory cell proper is OFF.

## Claims

1. A charge pumping semiconductor memory cell comprising a semiconductor substrate (3) of one conductivity type, a charge storage region (2), of opposite conductivity type to the semiconductor substrate, on or in the substrate, a source (6) and a drain (7) on or in the charge storage region, a gate (8), on a gate insulator layer (5), on the charge storage region and separating the source and drain, said charge storage region being electrically floating and for storing charge carriers, characterised in that a region (1) with an introduced plurality of recombination centres is provided in the charge storage region separate from the source and the drain, and beneath a zone in which a channel of the cell is generated, to capture minority charge carriers generated under said gate whereby charge pumping efficiency is increased.

2. A cell as claimed in claim 1, further characterised in that there is provided a transistor with a channel of a conductivity type different from that of said memory cell comprising an additional source or an additional drain (11), on or in the semiconductor substrate, and an additional gate (12), on a gate insulator layer, on the semiconductor substrate, separating the additional source or additional drain and the charge storage region, which transistor can be placed in an ON condition for erasing information held in the memory cell in the form of stored charge carriers (Fig. 5, 6 or 7).

3. A cell as claimed in claim 2, wherein the transistor comprises also an additional drain or an additional source (10) provided on or in the semiconductor substrate in electrical contact with the charge storage region (2), the said additional gate separating the additional source or additional drain and the additional drain or additional source (Fig. 5 or 7).

4. A cell as claimed in claim 2, wherein the additional gate (12) is so placed as to electrically contact the charge storage region (2), which region acts as an additional drain or an additional source of the transistor in relation to the additional gate and additional source or additional drain (Fig. 6).

5. A semiconductor memory cell as claimed in claim 2, 3 or 4, further comprising an area (13) of the same conductivity type as the source and drain of claim 1, in the neighborhood of the additional source or the additional drain (11) of claim 2, and on or in the substrate, in electrical contact with the additional source or additional drain of claim 2, connecting the additional source or additional drain of claim 2 to the substrate (Fig. 7).

6. A semiconductor memory device, characterised by a plurality of semiconductor memory cells each as claimed in any one of claims 1 to 5.

7. A device as claimed in claim 6, further comprising a control circuit, an address circuit, a writing circuit, a reading circuit, and an information refresh circuit.

**Patentansprüche**

1. Ladungspumpende Halbleiterspeicherzelle, mit einem Halbleitersubstrat (3) einer Leitfähigkeitsart, einer Ladungsspeicherzone (2), von entgegengesetzter Leitfähigkeitsart wie das Halbleitersubstrat, auf oder in dem Substrat, einer Sourcezone (6) und einer Drainzone (7), auf oder in der Ladungsspeicherzone, einer Gatezone (8), auf einer Gateisolierschicht (5), die sich auf der Ladungsspeicherzone befindet und die Sourcezone von der Drainzone trennt, wobei die Ladungsspeicherzone elektrisch schwebend ist und zur Speicherung der Ladungsträger dient, dadurch gekennzeichnet, daß eine Zone (1) mit einer eingeführten Anzahl von Rekombinationszentren in der Ladungsspeicherzone, getrennt von der Sourcezone und der Drainzone und unterhalb einer Zone, in welcher ein Kanal der Zelle erzeugt wird, vorgesehen ist, um Minoritätsladungsträger zu fangen, welche unter der Gatezone erzeugt werden, wodurch der Ladungspumpenwirkungsgrad erhöht wird.

2. Zelle nach Anspruch 1, ferner dadurch gekennzeichnet, daß ein Transistor mit einem Kanal von einer von derjenigen der genannten Speicherzelle verschiedenen Leitfähigkeitsart vorgesehen ist, welcher eine zusätzliche Sourcezone oder eine zusätzliche Drainzone (11) auf oder in dem Halbleitersubstrat umfaßt, und eine zusätzliche Gatezone (12) auf einer Gateisolierschicht auf dem Halbleitersubstrat, welche die zusätzliche Sourcezone oder die zusätzliche Drainzone von der Ladungsspeicherzone trennt, und welcher Transistor in den EIN-Zustand versetzt werden kann, um die in der Speicherzelle in Form von gespeicherten Ladungsträgern gehaltene Information zu löschen (Fig. 5, 6 oder 7).

3. Zelle nach Anspruch 2, bei welcher der Transistor auch eine zusätzliche Drainzone oder eine zusätzliche Sourcezone (10) umfaßt, welche auf oder in dem Halbleitersubstrat in elektrischem Kontakt mit der Ladungsspeicherzone (2) vorgesehen ist, bei welcher die genannte zusätzliche Gatezone die zusätzliche Sourcezone oder zusätzliche Drainzone von der zusätzlichen Drainzone oder zusätzlichen Sourcezone trennt (Fig. 5 oder 7).

4. Zelle nach Anspruch 2, bei welcher die zusätzliche Gatezone (12) so angeordnet ist, daß sie elektrisch die Ladungsspeicherzone (2) kontaktiert, welche als eine zusätzliche Drainzone oder eine zusätzliche Sourcezone des Transistors in Relation zu der zusätzlichen Gatezone und zusätzlichen Sourcezone oder zusätzlichen Drainzone wirkt (Fig. 6).

5. Halbleiterspeicherzelle nach Anspruch 2, 3 oder 4, welche ferner einen Bereich (13) vom selben Leitfähigkeitstyp wie die Sourcezone und Drainzone nach Anspruch 1, in der Nachbarschaft der zusätzlichen Sourcezone oder der zusätzlichen Drainzone (11) nach Anspruch 2, und auf oder in dem Substrat umfaßt, welche in elektrischem Kontakt mit der zusätzlichen Sourcezone oder zusätzlichen Drainzone nach Anspruch 2 ist, und die zusätzliche Sourcezone oder zusätzliche Drainzone nach Anspruch 2 mit dem Substrat verbindet (Fig. 7).

6. Halbleiterspeichervorrichtung, gekennzeichnet durch eine Anzahl von Halbleiterspeicherzellen jeweils nach einem der Ansprüche 1 bis 5.

7. Vorrichtung nach Anspruch 6, mit einer Steuerschaltung, einer Adressierschaltung, einer Schreibschaltung, einer Leseschaltung und einer Informationsauffrischungsschaltung.

**Revendications**

1. Cellule de mémorisation semi-conductrice à pompage de charge comprenant un substrat semi-conducteur (3) d'un premier type de conductivité, une région (2) d'emmagasinage de charge, d'un type de conductivité opposé à celui du substrat semiconducteur sur ou dans le substrat, une source (6) et un drain (7) sur ou dans la région d'emmagasinage de charge, une grille (8) sur une couche (5) isolante de grille, elle-même sur la région d'emmagasinage de charge et séparant la source et le drain, ladite région d'emmagasinage de charge étant électriquement flottante et étant destinée à emmagasiner des porteurs de charge, caractérisée en ce qu'une region (1) dotée d'une pluralité introduite de centres de recombinaison est prévue dans la région d'emmagasinage de charge séparée de la source et du drain, et au-dessous d'une zone dans laquelle un canal de la cellule est produit, pour capturer des porteurs de charge minoritaires produits sous ladite grille de manière à accroître le rendement de pompage de charge.

2. Cellule selon la revendication 1, caractérisée en outre en ce qu'il est prévu un transistor doté d'un canal d'un type de conductivité différent de celui de ladite cellule de mémorisation comprenant une source supplémentaire ou un drain supplémentaire (11) sur ou dans le substrat semi-conducteur et une grille supplémentaire (12) sur une couche isolante de grille, elle-même sur le substrat semiconducteur, séparant la source supplémentaire ou le drain supplémentaire et la région d'emmagasinage de charge, lequel transistor peut être placé dans un état conducteur pour effacer l'information maintenue dans la cellule de mémorisation sous forme de porteurs de charge emmagasinés (figure 5, 6 ou 7).

3. Cellule selon la revendication 2, où le transistor comprend également un drain supplémentaire ou une source supplémentaire (10) disposé sur ou dans le substrat semi-conducteur en contact électrique avec la région (2) d'emmagasinage de charge, ladite grille supplémentaire séparant la source supplémentaire ou le drain supplémentaire et le drain supplémentaire ou la source supplémentaire (figure 5 ou 7).

4. Cellule selon la revendication 2, où la grille supplémentaire (12) est placée de façon à être en contact électrique avec la région (2) d'emmagasinage de charge, laquelle région fait fonction de drain supplémentaire ou de source supplémentaire du transistor relativement à la grille supplémentaire et à la source supplémentaire ou le drain supplémentaire (figure 6).

5. Cellule de mémorisation semi-conductrice selon la revendication 2, 3 ou 4, comprenant en outre une aire (13) du même type de conductivité que la source et le drain de la revendication 1, dans le voisinage de la source supplémentaire ou du drain supplémentaire (11) de la revendication 2, et sur ou dans le substrat, en contact électrique avec la source supplémentaire ou le drain supplémentaire de la revendication 2, connectant la source supplémentaire ou le drain supplémentaire de la revendication 2 ou substrat (figure 7).

6. Dispositif de mémorisation semi-conducteur, caractérisé par plusieurs cellules de mémorisation semi-conductrices, chacune selon l'une quelconque des revendications 1 à 5.

7. Dispositif selon la revendication 6, comprenant en outre un circuit de commande, un circuit d'adresse, un circuit d'écriture, un circuit de lecture et un circuit de renouvellement d'information.

FIG. 1

FIG. 2

FIG. 3

FIG. 4

FIG. 5

FIG. 6

3

FIG. 7

FIG. 8

**FIG. 9**

**FIG. 10**